(19) Europäisches Patentamt
European Patent Office
Office européen des brevets

(11) EP 2 323 327 A2

(12) EUROPEAN PATENT APPLICATION

(43) Date of publication:
18.05.2011 Bulletin 2011/20

(51) Int Cl.:
H04L 27/26 (2006.01)   H03M 3/04 (2006.01)

(21) Application number: 10191408.3

(22) Date of filing: 16.11.2010

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 16.11.2009 US 619661

(71) Applicant: NXP B.V.
5656 AG Eindhoven (NL)

(72) Inventors:
• Van Houtem, Wilhelmus J.
5656 AE, Eindhoven (NL)
• Willems, Frans M.J.
5656 AE, Eindhoven (NL)

(74) Representative: Krott, Michel
NXP Semiconductors B.V.
IP & Licensing Department
High Tech Campus 32
5656 AE  Eindhoven (NL)

(54) **System and method for demodulating and decoding a differentially encoded COFDM (coded orthogonal frequency division multiplexing) modulation code using two-dimensional code blocks**

(57)    A system and method for demodulating and decoding a differentially encoded modulation code from a coded orthogonal frequency division multiplexing (COFDM) transmitter involves partitioning the differentially encoded modulation code into two-dimensional code blocks and demodulating and decoding the two-dimensional code blocks to produce demodulated and decoded information.

FIG. 1

**Description**

Embodiments of the invention relate generally to modulation systems and methods and, more particularly, to a system and method for demodulating and decoding a differentially encoded (DE) coded orthogonal frequency division multiplexing (COFDM) modulation code.

DE-COFDM modulation codes can be demodulated using non-coherent demodulation, which is more robust against ambiguities and impairments on phases of the DE-COFDM modulation codes compared to coherent demodulation. However, non-coherent demodulation is inferior to coherent demodulation with respect to performance. Using iterative non-coherent demodulation on DE-COFDM modulation codes can close the performance gap between non-coherent demodulation and coherent demodulation. However, by applying joint and iterative non-coherent demodulation and decoding, the complexity of a receiver may increase considerably and the loss in iterative coding gain may be dramatic, which lead to serious drawbacks for the receiver. Therefore, there is a need to provide a system and method for demodulating and decoding DE-COFDM modulation codes that achieves a low receiver complexity and a high coding gain.

A system and method for demodulating and decoding a DE modulation code from a COFDM transmitter involves partitioning the DE modulation code into two-dimensional code blocks and demodulating and decoding the two-dimensional code blocks to produce demodulated and decoded information. By partitioning the DE modulation code into two-dimensional code blocks and performing demodulating and decoding on the two-dimensional code blocks, the performance gap between non-coherent demodulation and coherent demodulation can be closed while a low receiver complexity and a high coding gain are achieved.

In an embodiment, a method for demodulating and decoding a DE modulation code from a COFDM transmitter includes partitioning the DE modulation code into two-dimensional code blocks and demodulating and decoding the two-dimensional code blocks to produce demodulated and decoded information.

In an embodiment, a system for demodulating and decoding a DE modulation code from a COFDM transmitter includes a partitioning module and a demodulating and decoding module. The partitioning module is configured to partition the DE modulation code into two-dimensional code blocks. The demodulating and decoding module is configured to demodulate and decode the two-dimensional code blocks to produce demodulated and decoded information.

In an embodiment, a method for demodulating and decoding a DE modulation code from a COFDM transmitter includes partitioning the DE modulation code into two-dimensional code blocks and demodulating and decoding the two-dimensional code blocks to produce demodulated and decoded information, where demodulating and decoding the two-dimensional code blocks includes performing trellis decoding on each of the two-dimensional code blocks.

Other aspects and advantages of embodiments of the present invention will become apparent from the following detailed description, taken in conjunction with the accompanying drawings, depicted by way of example of the principles of the invention.

Fig. 1 shows a schematic block diagram of a COFDM transmitter and a system for demodulating and decoding in accordance with an embodiment of the invention.
Fig. 2 shows a schematic block diagram of a COFDM transmitter and a system for demodulating and decoding in accordance with another embodiment of the invention.
Figs. 3 and 4 depict exemplary two-dimensional code blocks that can be used by the system depicted in Fig. 2.
Fig. 5 illustrates an exemplary trellis states map that can be used by the system depicted in Fig. 2.
Figs. 6 and 7 depict performance simulation results of a single carrier Peleg-trellis inner-decoder and a multi-carrier Peleg-trellis inner-decoder in accordance with different embodiments of the invention.
Fig. 8 is a process flow diagram of a method for demodulating and decoding a DE modulation code from a COFDM transmitter in accordance with an embodiment of the invention.

Throughout the description, similar reference numbers may be used to identify similar elements.

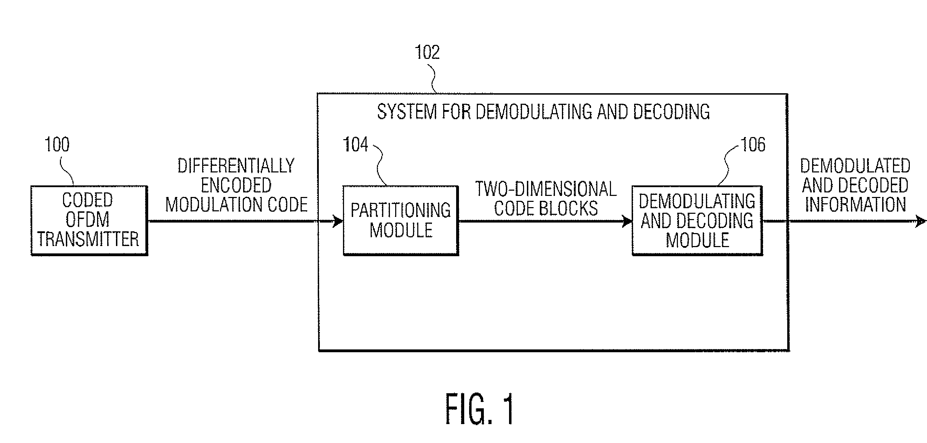

Fig. 1 shows a schematic block diagram of a coded OFDM (COFDM) transmitter 100 and a system 102 for demodulating and decoding in accordance with an embodiment of the invention. The demodulating and decoding system receives at least one DE modulation code from the COFDM transmitter and demodulates and decodes the DE modulation code to produce demodulated and decoded information. The demodulating and decoding system may be a component of a wireless receiver or a wired receiver. For example, the demodulating and decoding system may be a component of a Digital Audio Broadcasting (DAB) receiver, a DAB+ receiver or a Terrestrial-Digital Multimedia Broadcasting (T-DMB) receiver. In the illustrated embodiment, the system includes a partitioning module 104 and a demodulating and decoding module 106.

The partitioning module 104 of the demodulating and decoding system 102 is configured to partition the DE modulation code into two-dimensional code blocks. In an embodiment, the DE modulation code includes COFDM symbols and the partitioning module partitions the COFDM symbols into two-dimensional code blocks such that each of the two-dimensional code blocks includes multiple COFDM symbols. Each of the multiple COFDM symbols may include at least two DE symbols, and each of the DE symbols may be transmitted in a different OFDM subcarrier. Thus, the partitioning module may receive each of the DE symbols in a different OFDM subcarrier.

The demodulating and decoding module 106 of the demodulating and decoding system 102 is configured to demodulate and decode the two-dimensional code blocks that are received from the partitioning module 104 to produce demodulated and decoded information. In some embodiments, the demodulating and decoding module jointly demodulates and decodes the two-dimensional code blocks. For example, the demodulating and decoding module demodulates the two-dimensional code blocks using information from decoding the two-dimensional code blocks and decodes the two-dimensional code blocks using information from demodulating the two-dimensional code blocks. In some embodiments, the demodulating and decoding module jointly and iteratively demodulates and decodes the two-dimensional code blocks. The demodulating and decoding module may jointly and iteratively demodulate and decode the two-dimensional code blocks by performing trellis decoding. For example, the demodulating and decoding module includes a Peleg-trellis inner-decoder (not shown) that performs trellis decoding on each of the two-dimensional code blocks and a trellis decoder (not shown) to decode, for example, convolutionally encoded bits in an iterative manner. In an embodiment, for each of the DE symbols of a two-dimensional code block, the Peleg-trellis inner-decoder of the demodulating and decoding module sets discrete phases, which may be equally spaced from each other, to represent trellis states and compares the phase of the DE symbol with the discrete phases to select a trellis state for the DE symbol from the trellis states. The Peleg-trellis inner-decoder of the demodulating and decoding module may uniquely determine a path through the trellis states using the discrete phases of the DE symbols of a two-dimensional code block.

In an embodiment, the DE modulation code includes concatenated DE symbols, which are included in at least one two-dimensional code block. In this embodiment, the demodulating and decoding system 102 may receive the concatenated DE symbols in adjacent OFDM subcarriers and the demodulating and decoding module 106 may perform trellis decoding on the concatenated DE symbols successively. Out of the concatenated DE symbols, some concatenated DE symbols may belong to a single COFDM symbol.

The demodulating and decoding module 106 may perform joint and iterative demodulation and decoding on two-dimensional code blocks of a DE modulation code. In an embodiment, the demodulating and decoding module obtains, at its input, reliability information about the DE symbols of a two-dimensional code block, calculates a-posteriori probability information of transitions between the trellis states using the reliability information about coded bits that are contained in the phase difference of two consecutive DE symbols, which may be provided by an outer-decoder (not shown), and performs trellis decoding on the two-dimensional code block using the calculated a-posteriori probability information. By first partitioning the DE modulation code into two-dimensional code blocks and then performing joint and iterative demodulation and decoding on the partitioned two-dimensional code blocks, the performance gap between non-coherent demodulation and coherent demodulation can be closed while the receiver complexity can be considerably reduced with almost no loss in iterative coding gain when compared to joint and iterative demodulation and decoding without first partitioning the DE modulation code into two-dimensional code blocks.

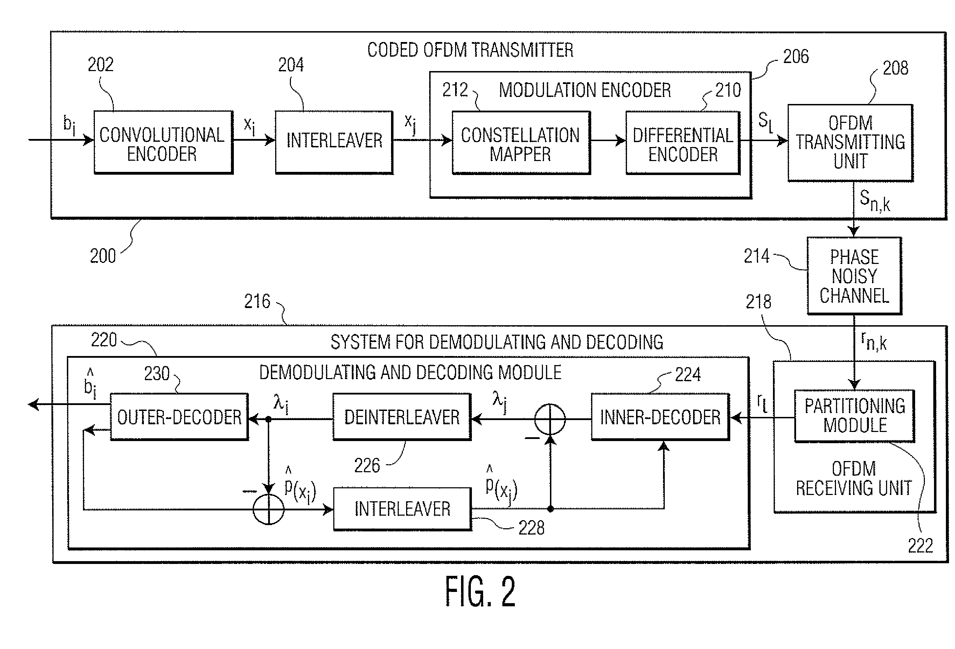

Turning now to Fig. 2, a coded OFDM (COFDM) transmitter 200 and a system 216 for demodulating and decoding in accordance with another embodiment of the invention are shown. The COFDM transmitter includes a convolutional encoder 202, an interleaver 204 such as a one bit-wise uniform block interleaver, a modulation encoder 206 and an OFDM transmitting unit 208. The convolutional encoder may generate a rate = 1/2 convolutional code using generator polynomials 133 and 171. The modulation encoder includes a differential encoder 210 and a constellation mapper 212, which may be a quadrature phase-shift keying (QPSK) mapper that maps a bit pair to one QPSK symbol by Gray encoding. The COFDM transmitter transmits at least one DE modulation code through a phase noise channel 214 to the demodulating and decoding system.

As shown in Fig. 2, the demodulating and decoding system 216 includes an OFDM receiving unit 218 and a demodulating and decoding module 220. The OFDM receiving unit receives at least one DE modulation code that is transmitted from the COFDM transmitter 200 and the demodulating and decoding module demodulates and decodes the DE modulation code to produce demodulated and decoded information.

In the embodiment of Fig. 2, the OFDM receiving unit 218 of the demodulating and decoding system 216 includes a partitioning module 222 that is configured to partition the received DE modulation code into two-dimensional code blocks. The DE modulation code includes multiple COFDM symbols and each of the COFDM symbols includes multiple DE symbols. The OFDM receiving unit receives the multiple DE symbols in multiple OFDM subcarriers and the partitioning module partitions the multiple COFDM symbols into the two-dimensional code blocks such that each of the two-dimensional code blocks includes multiple COFDM symbols and is spread over multiple OFDM subcarriers.

The demodulating and decoding module 220 of the system 216 includes an inner-decoder 224, a deinterlaver 226, an interleaver 228 and an outer-decoder 230. The demodulating and decoding module is configured to demodulate and decode the two-dimensional code blocks that are generated from the partitioning module 222. The inner-decoder, which may be a Peleg-trellis inner-decoder, is configured to perform trellis decoding on each of the two-dimensional code blocks. For each of the DE symbols of a two-dimensional code block, the inner-decoder sets discrete phases, which may be equally spaced from each other, to represent trellis states and compares the phase of the DE symbol with the discrete phases to select a trellis state for the DE symbol from the trellis states. A path through the trellis states is uniquely determined using the discrete phases of the DE symbols of a two-dimensional code block. The inner-decoder is further configured to calculate a-posteriori probability information of transitions between the trellis states, where these transitions represent symbols, for example, QPSK symbols, which contain coded bits that need to be decoded by the outer-decoder. Specifically, the inner-decoder obtains, at its input, reliability information about DE symbols, for example, DE-QPSK symbols, of the two-dimensional code block, where the phase differences between two consecutive DE - QPSK symbols represent QPSK symbols that contain coded bits that need to be decoded by the outer-decoder. Then, the inner-decoder performs trellis decoding on the two-dimensional code block by calculating a-posteriori probability information of these QPSK symbols with a forward-backward decoding algorithm also known as the BCJR algorithm, as described in L. Bahl, J. Cocke, F. Jelinek, and J. Raviv, "Optimal decoding of linear codes for minimizing symbol error rate (corresp)," Information Theory, IEEE Transactions on, vol. 20, no. 2, pp. 284-287, Mar 1974, and using a-posteriori probability information from the outer decoder as a-priori probability input information. In summary, the inner-decoder calculates a-posteriori probability information of transitions between the trellis states, where these transitions represent symbols that contain coded bits for decoding by the outer-decoder, using a-priori reliability information that is provided by the outer-decoder in an iterative manner about the coded bits. A DE code is regarded as an inner component code that is to be decoded by the inner-decoder and a convolutionally encoded (CE) code is regarded as an outer component code that is to be decoded by the outer-decoder. In other words, a DE symbol that is generated by the differential encoder 210 is decoded by the inner-decoder and a CE symbol that is generated by the convolutional encoder 202 is decoded by the outer-decoder.

The outer-decoder 230, which may be a trellis decoder, decodes a convolutional code generated by the convolutional encoder 202. Similar to the inner-decoder 224, the outer-decoder uses trellis states and transitions between the trellis states for decoding. However, the outer-decoder and the inner-decoder have different trellis states and transitions between the trellis states. In other words, compared to the inner-decoder, the outer-decoder uses a separate trellis. The outer-decoder may, also as the inner-decoder, employ the BCJR algorithm. Specifically, the outer-decoder decodes the convolutional codes by calculating a-posteriori probability information about coded bits " $x_i$ " and information bits " $b_i$." The outer-decoder provides, via the BCJR algorithm, soft-decision information (a-posteriori probabilities) "$P(x_i)$" of the coded bits "$x_i$" to be used as a-priori reliability information for the inner-decoder to improve its a-posteriori reliability information of the symbols, for example, QPSK symbols, which contain coded bits that need to be decoded by the outer-decoder. In an embodiment, the inner-decoder uses the a-priori reliability information from the outer-decoder to decode QPSK symbols, which are represented by transitions between trellis states, i.e., phase differences between two consecutive DE-QPSK symbols, that contain the interleaved coded-bits "$\hat{x}_j$". Furthermore, the a-posteriori reliability information generated by the outer-decoder about the information bits "$\hat{b}_i$" is used to make hard-decisions after a desired number of iterations, i.e., zero and one bit decisions. Compared to a Viterbi convolutional decoder, which only makes hard decisions on the information bits and normally cannot give reliability information of the coded-bits, the outer-decoder that employs the BCJR algorithm has also soft-output available, which is required for iterative decoding, in particular, soft-decision information of the coded-bits.

In an embodiment, the deinterleaver 226 is a random deinterleaver and the interleaver 228 is a random interleaver. In this embodiment, the deinterleaver is configured to provide randomness in the input probability for the outer-decoder 230, while the interleaver is configured to provide randomness in the a-priori input probability for the inner-decoder 224. In each iteration of the demodulating and decoding process, the a priori probabilities for the inner-decoder coming as a-posteriori probabilities of the coded bits from the outer-decoder and the input probabilities for the outer-decoder coming as a-posteriori probabilities of the coded bits from the inner-decoder are randomly distributed and the randomly distributed input reliability information is used, per iteration, to decode the same two-dimensional code block again. Additionally, the interleaver may take the multiple bits that are in one symbol apart, which makes the assumption that a priori input distributions of symbols can be represented as the product of marginal distributions of bits is valid. In other embodiments, the deinterleaver may be a pseudo-random block deinterleaver or a convolutional deinterleaver and the interleaver may be a pseudo-random block interleaver or a convolutional interleaver. For example, the deinterleaver may be a one bit-wise uniform block deinterleaver and the interleaver may be a one bit-wise uniform block interleaver. Compared to the random deinterleaver and the random interleaver, the performance gain may decrease using a pseudo-random block interleaver/deinterleaver or a convolutional interleaver/deinterleaver.

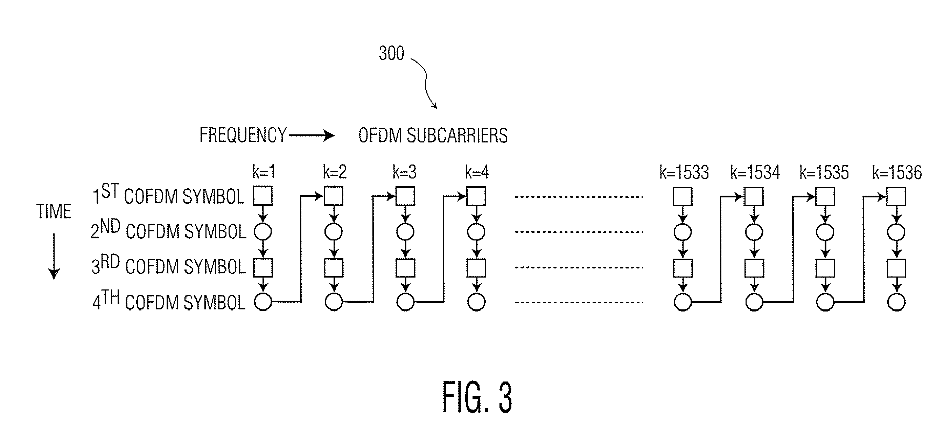

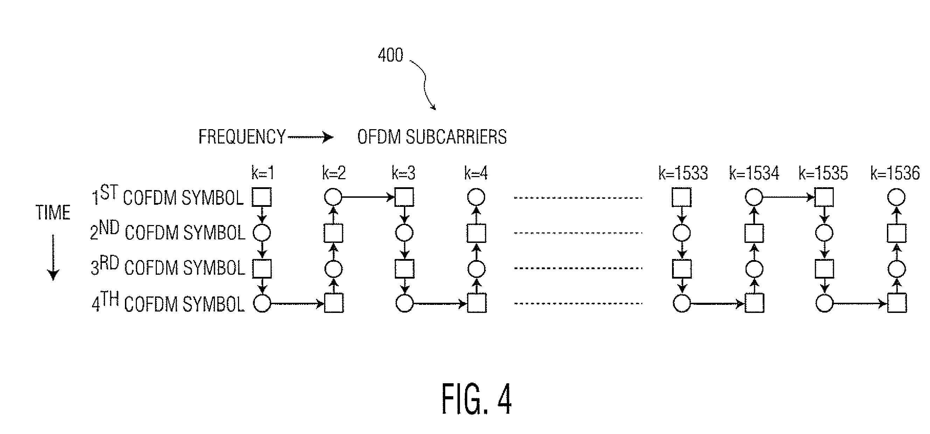

Figs. 3 and 4 depict exemplary two-dimensional code blocks 300, 400 that can be used by the demodulating and decoding system 216 depicted in Fig. 2. As shown in Figs. 3 and 4, each of the two-dimensional code blocks includes four COFDM symbols, where each of the COFDM symbols includes 1,536 DE symbols that are transmitted in 1,536 different OFDM subcarriers. Overall, both of the four COFDM symbols in Figs. 3 and 4 include 4x1,536=6,144 DE symbols, which can be used under Mode-I for DAB-family broadcast systems. Although each of the two-dimensional code blocks includes four COFDM symbols and each of the COFDM symbols includes 1,536 DE symbols in the embodiments depicted in Figs. 3 and 4, a two-dimensional code block may include less than or more than four COFDM symbols and each of the COFDM symbols may include less than or more than 1,536 DE symbols in other embodiments.

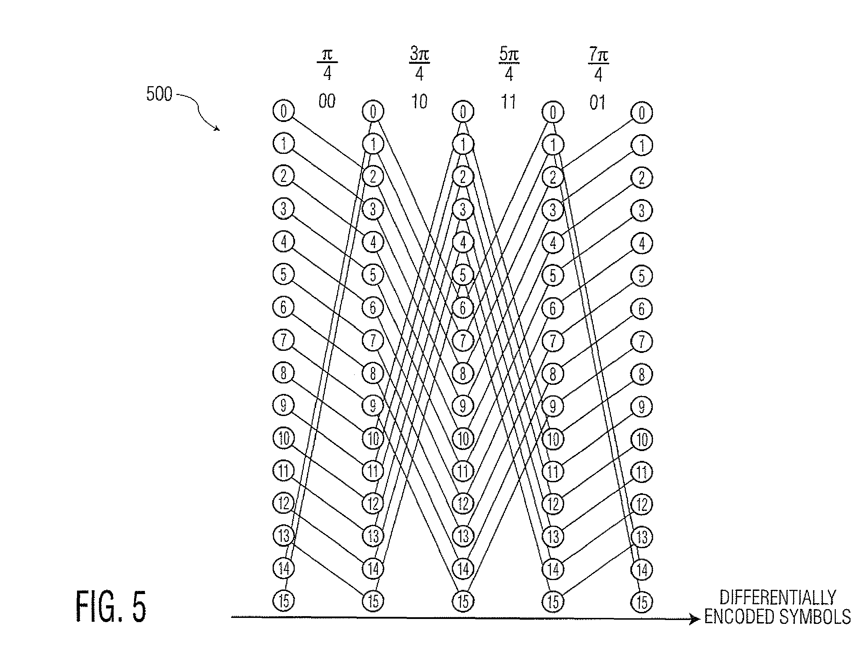

The OFDM receiving unit 218 of the demodulating and decoding system 216 may receive concatenated DE symbols in adjacent OFDM subcarriers, which are included in a single two-dimensional code block, and the inner-decoder 224 then performs trellis decoding on the concatenated DE symbols successively. For example, in Figs. 3 and 4, DE symbols received in OFDM subcarriers 1-1536 are concatenated. Concatenated DE symbols may belong to different COFDM symbols. For example, in Fig. 3, the DE symbol of the 4th COFDM symbol that is received in the first OFDM subcarrier is concatenated to the DE symbol of the 1st OFDM symbol that is received in the second OFDM subcarrier. The symbol concatenation in Fig. 3 can be called "snake concatenation." When the constellation mapper 212 is a QPSK constellation mapper, in the snake concatenation, the modulation constellation for the QPSK symbols mapped according to the constellation mapper 212 is preserved, which means that the QPSK symbols representing the phase differences of two consecutive DE-QPSK symbols are conforming, i.e., these QPSK symbols can be mapped to the QPSK modulation constellation as generated by the constellation mapper 212. Alternatively, two consecutive DE symbols such as two consecutive DE-QPSK symbols may belong to a single COFDM symbol. For example, in Fig. 4, the DE-QPSK symbol of the 4th COFDM symbol that is received in the first OFDM subcarrier is concatenated to the DE-QPSK symbol of the 4th COFDM symbol that is received in the second OFDM subcarrier. The symbol concatenation in Fig. 4 can be called "sneaky snake concatenation." In the sneaky snake concatenation, the QPSK symbols representing the phase differences of two consecutive DE-QPSK are not conforming to the modulation constellation generated by the constellation mapper, if in each even column the circles and squares are not reversed. Reversing means circle become squares and squares become circles by multiplying the DE-QPSK symbols with $e^{j\pi/4}$ or $e^{-j\pi/4}$. Not being conforming to the QPSK modulation constellation means that the QPSK symbols representing the phase differences of two consecutive DE-QPSK symbols are not conforming, i.e., cannot be mapped to the QPSK modulation constellation as generated by the constellation mapper 212. To be according to the QPSK constellation generated by the constellation mapper for each even column of DE-QPSK symbols, the order of the "circles" and the "squares" are as shown in Fig. 4. Compared to the snake concatenation, the sneaky snake concatenation has the advantage that the symbols are concatenated at the same time instance such that the sneaky snake concatenation does not cause a "time jump," which could be disadvantageous in time varying channels. In an embodiment, the concatenated DE symbols have phase differences that belong to $\pi/4$, $3\pi/4$, $5\pi/4$ and $7\pi/4$ in a QPSK constellation diagram. In this embodiment, a "square" shown in Figs. 3 and 4 represents a DE-QPSK symbol with a phase of 0, $\pi/2$, $\pi$ or $3\pi/2$ in a QPSK-constellation diagram and a "circle" shown in Figs. 3 and 4 represents a DE-QPSK symbol with a phase of $\pi/4$, $3\pi/4$, $5\pi/4$ or $7\pi/4$ in a QPSK-constellation diagram. For trellis decoding performed by the inner-decoder with a trellis according to Fig. 5, a transition from a "square" to a "circle" or from a "circle" to a "square" is allowed, while a transition from a "circle" to another "circle" or from a "square" to another "square" is not allowed.

Fig. 5 illustrates an exemplary trellis states map 500 that can be used by the demodulating and decoding system 216 depicted in Fig. 2. As shown in Fig. 5, a trellis has sixteen states, where each state represents an angle at which a DE symbol could be received. In an example of $\pi/4$-QPSK constellation mapping, a QPSK symbol $\theta$ has four possible discrete values, $\theta_i = \dfrac{\pi}{4} \times i$, with i ∈ [1,3,5,7], which represent coded bits "00," "10," "11" and "01." The phase difference between two consecutive DE symbols is the differential phase information $\theta$ and is mapped to a QPSK symbol that represents the coded bits. For DAB-family broadcast systems, the QPSK symbols that represent the coded bits are only available in time-direction, i.e., per OFDM-subcarrier. Thus, for the QPSK symbols between consecutive DE-QPSK symbols that come from two different OFDM subcarriers, the a-posteriori reliabilities that are calculated by the inner-decoder 224 for these QPSK symbols are not used in the iterative process because no coded bits are represented by these QPSK symbols. However, the a-posteriori reliabilities that are calculated by the inner-decoder for these QPSK symbols are required to extend the length of the trellis for the inner-decoder, i.e., the two-dimensional extension to the product of the multiple COFDM symbols and multiple OFDM subcarriers to overcome the loss in Multi-Symbol Differential Detection (MSDD) iterative coding gain by per service symbol processing with a single-carrier trellis inner-decoder, i.e. an inner-decoder that is only capable of generating a-posteriori probabilities of the QPSK symbols between two consecutive DE-QPSK per OFDM subcarrier. The a-posteriori reliabilities from the QPSK symbols between two consecutive DE-QPSK symbols coming from two different OFDM subcarriers are "skipped" and are not going into the deinterleaving process performed by the deinterlaver 226 and the convolutional decoding process performed by the outer-decoder 230. The a-priori reliability information of these QPSK symbols between two consecutive DE-QPSK symbols coming from two different OFDM subcarriers is set to ¼, which represents equal a-priori probability for each of the four possible QPSK symbols because the outer decoder cannot provide the inner-decoder with a-priori reliability information for these QPSK symbols due to the fact that they do not represent coded bits. The states of the trellis represent the phases of the DE symbols and, consequently, the transitions between the states correspond to the phase differences that represent the coded bits. If the phase differences are {$\pi/4$, $3\pi/4$, $5\pi/4$ or $7\pi/4$}, then the phases of the differentially encoded symbols either are {0, $\pi/2$, $\pi$ or $3\pi/2$} shown by the "squares" in Figs. 3 and 4 or are {$\pi/4$, $3\pi/4$, $5\pi/4$ or $7\pi/4$} shown by the "circles" in Figs. 3 and 4. As shown in Fig. 5, an arrow from one state to a another state indicates the possible transition between two consecutive DE-QPSK symbols, which represents a QPSK symbol that contains coded bits that need to be decoded by the outer-decoder 230. In an embodiment, the trellis-based inner-decoder 224 calculates reliability information, i.e., a-posteriori probability (APP) about differential phase information that represents the coded bits. These differential phase information, which are phase differences between DE symbols, belongs to the set {$\pi/4$, $3\pi/4$, $5\pi/4$ or $7\pi/4$} in the DAB-family broadcast systems and is generated by the QPSK-mapper 212. The differential encoder 210 generates differentially encoded symbols whose phases belong to the sets {0, $\pi/2$, $\pi$ or $3\pi/2$} or {$\pi/4$, $3\pi/4$, $5\pi/4$ or $7\pi/4$}, which are respectively represented by the "squares" or the "circles" in both Figs. 3 and 4. As shown in Fig. 5, the arrow from state "0" of the "n"th DE-QPSK symbol to state "2" of the "n+1" th DE-QPSK symbol indicates the possible transition from state "0" of the "n"th DE-QPSK symbol to the state "2" of the "n+1" th DE-QPSK symbol. Although a trellis has sixteen states in the trellis states map illustrated in Fig. 5, a trellis may have less than or more than sixteen states in other embodiments.

An exemplary operation of the COFDM transmitter 200 and the demodulating and decoding system 216 depicted in Fig. 2 is described as follows. The convolutional encoder 202 of the COFDM transmitter encodes sequences of information bits "$b_i$" into sequences of coded bits "$x_i$." The interleaver 204 then interleaves the sequences of coded bits "$x_i$" into a sequence of bits "$x_j$." The modulation encoder 206 generates a sequence of DE QPSK symbols "$s_l$" from the sequence of bits "$x_j$." The OFDM transmitting unit 208 then modulates each DE-QPSK symbol to an OFDM subcarrier at frequency $f_k = \dfrac{k}{T_u}$, where $T_u$ is the duration of a COFDM symbol and $k$ represents the sequence number of the OFDM subcarrier. Consequently, the OFDM transmitting unit modulates the sequence of DE-QPSK symbols "$s_l$" into a sequence of DE-QPSK symbols "$s_{n,k,}$" where n represents the sequence number of the COFDM symbol and k represents the sequence number of the OFDM subcarrier. At time $t_n = nTu$ and at frequency $f_k = \dfrac{k}{T_u}$, , a DE-QPSK symbol $s_{n,k}$ =exp($j\Psi_{n,k}$) is sent over an additive white Gaussian noise (AWGN) channel 214 with phase noise:

$$r_{n,k}= s_{n,k} \times \exp(j\,\theta_{n,k})+w_{n,k}= \exp(j[\varphi_{n,k}+\theta_{n,k}])+w_{n,k}= \exp(j\psi_{n,k}) +w_{n,k} \qquad (1)$$

where $w_{n,k}$ models the complex AWGN channel with the variance of its real and imaginary components as $\sigma^2 = \dfrac{N_0}{2E_s}$, $E_s$ represents the energy per DE-QPSK symbol, $N_0$ represents power of the noise, and the discrete time phase noise $\theta_{n,k}$ is modeled as a Gaussian random walk (GRW). For the GRW model, the phase increments $\Delta\theta_{n,k}$ are independently identically distributed (i.i.d.) random variables (r.v.) with a standard deviation of $\sigma_\theta$ radians in each DE-QPSK symbol. The discrete time phase noise is then:

$$\theta_{n,k}= \theta_{n-1,k-1}+ \Delta\theta_{n,k} \qquad\qquad (2)$$

where the initial phase $\theta_{1,1}$ is a uniformly distributed random variable. Moreover, the discrete time representation of the AWGN channel, given by equations (1) and (2), is valid for AWGN channels with a constant carrier phase that employs both match filtering and sampling at the receiver. In addition, the discrete time channel that satisfies equations (1) and (2) serves as a good approximation if the noisy phase change is small during one DE-QPSK symbol. Although phase noisy AWGN channel is given as an example, other channel models may be used as long as, within each two-dimensional code blocks, the unknown channel phase is nearly fixed, and thus, the standard deviation $\sigma_\theta$ of the phase noisy AWGN channel is nearly zero, specifically, for the AWGN channel $\sigma_\theta$=0. In an embodiment, the size of each two-dimensional code block is adjusted to a particular value so that the unknown channel-phase is nearly fixed within each two-dimensional code block.

According to the discrete time channel representation given by equations (1) and (2), for the modulation system 216 with K subcarriers per COFDM symbol, the DE-QPSK symbols ($r_{n,1}...,r_{n,K}$) of the $n^{th}$ COFDM-symbol is available at the OFDM receiving unit 218 at time instance $T_n = T_0 + n \times T_u$, where $T_0$ is the starting time of the OFDM receiving process of the OFDM receiving unit. At time instance $T_{n+1} = T_0 + (n+1) \times T_u = T_n + T_u$, the DE-QPSK symbols $(r_{n+1,1},...,$ $r_{n+1,k})$ of the $n+1^{th}$ OFDM symbol are available at the OFDM receiving unit. After N COFDM symbols are received at the OFDM receiving unit, a two-dimensional code block with a size of $S_{2D} = [N \times K]$ that contains a DE modulation code of a length of L = NK with "$r_1,...,r_l$" DE-QPSK symbols is available at the OFDM receiving unit. In other words, the two-dimensional code block with the size $S_{2D} = [N \times K]$ includes DE-QPSK symbols that are collected within a time interval of $T_B = N \times T_u$ and within a frequency-range of $W_B = K \times \Delta f = \dfrac{K}{T_u} \cdot$. The L DE-QPSK symbols may be divided into smaller blocks. In an example, each of the smaller blocks has a size of sixteen. In other words, each of the smaller blocks includes DE-QPSK symbols of four COFDM symbols and received in four OFDM subcarriers. In this case, one big block of $4 \times 1536$ DE-QPSK symbols can be divided into 384 smaller $4 \times 4$ blocks by the partitioning module 222 according to Fig. 3 or Fig. 4, but is not limited to these examples.

In this exemplary embodiment, the inner-decoder 224 is a single-carrier Peleg-trellis inner-decoder. The single-carrier Peleg-trellis inner-decoder can demodulate DE symbols only in one direction, either time direction or frequency direction. In the time direction, the single-carrier Peleg-trellis inner-decoder can demodulate only DE symbols in one OFDM subcarrier. In the frequency direction, the single-carrier Peleg-trellis inner-decoder can demodulate only DE symbols of one COFDM symbol. However, by combining the single-carrier Peleg-trellis inner-decoder 224 with the partitioning module 222, two-dimensional block based demodulation of the DE modulation code from the COFDM transmitter 200 with the successively improved estimates "$\hat{P}(x_j)$" of the coded bits "$x_j$" as a-priori information can be performed. In addition, it is possible that within the two dimensional blocks the phase differences of two consecutive DE-QPSK symbols that are represented by QPSK symbols, do not contain coded bits. For example, in the DAB-family broadcast systems, the QPSK symbols between two consecutive DE-QPSK symbols coming from two different OFDM subcarriers do not contain coded bits. These QPSK symbols will be "skipped," i.e., not going into the deinterleaver 226 for processing and the a-priori information of these QPSK symbols will be set to a predefined value such as ¼ for the inner-decoder. The combination of the single-carrier Peleg-trellis inner-decoder, the partitioning module, and the skipping of the QPSK symbols that do not contain coded bits and setting the a-priori information for these QPSK symbols to a predefined value is also called a multi-carrier Peleg-trellis inner-decoder. Using the multi-carrier Peleg-trellis inner-decoder, the phase of each DE-QPSK symbol, $arg(r_l) = \Psi_l$, is discretized into, for example, thirty-two equally spaced

values $\psi^q = q \times \dfrac{\pi}{16}$ for q = 0,..., 31 and the equally spaced values represent the thirty-two states of the trellis. A path η through the trellis is uniquely determined by the discretely distributed phases of the L DE-QPSK symbols $\{\Psi_l = \theta_1 + \varphi_1\}$, $l = 1,...,L$ within the two-dimensional code block with, for example, the size of $S_{2D} = [N \times K]$. To demodulate the information phases, i.e., the phases of the QPSK symbols, $\Delta\varphi_1 = arg(r_l) - arg(r_{l-1})$, $l = 1,...,L-1$, the inner-decoder calculates the a-posteriori probability (APP) information of the transitions between the trellis states, which can be obtained using the BCJR algorithm and performing trellis decoding with input reliability information of the DE-QPSK symbols i.e., the DE-QPSK symbol-metric:

$$P_r\{r_l \mid \psi_l = \psi^p\} = \frac{1}{2\pi\sigma^2}\exp(-\frac{\mid r_l - \mid r_l \mid \exp(j\psi_l)\mid^2}{2\sigma^2})\ l = 1,...,L \qquad (3)$$

and with, in an iterative manner coming from the outer-decoder 230, a-priori reliability information of the QPSK symbols that contain coded bits. The deinterleaver is a one bit-wise uniform block deinterleaver generated for each block of probabilities "$\lambda_j$," which results in a sequence of probabilities "$\lambda_i$." The outer decoder yields estimates "$\hat{b}_i$" of the information bits "$b_i$" of the COFDM transmitter and also successively improved estimates "$\hat{P}(x_i)$" of the coded bits "$x_i$" that are fed

back via a one bit-wise uniform block interleaver 228 to the inner decoder giving the a-priori reliability $_l$ "$\hat{P}(x_j)$" of the interleaved coded bits "$x_j$", where bit-pairs $(x_j, x_{j+1})$ represent QPSK symbols, i.e., transitions between trellis states of the inner-decoder.

In the above-described exemplary operation, a multi-carrier Peleg-trellis inner-decoder, which is a combination of the single-carrier Peleg-trellis inner-decoder 224, the partitioning module 222, and the skipping of the QPSK symbols that do not contain coded bits and setting the a-priori information for these QPSK symbols to a predefined value, is used. Compared to a single-carrier Peleg-trellis inner-decoder, a multi-carrier Peleg-trellis inner-decoder reduces the receiver complexity with almost no loss in iterative coding gain. As described above, a single-carrier Peleg-trellis inner-decoder can demodulate DE symbols only in one direction, either time direction or frequency direction. In the time direction, the single-carrier Peleg-trellis inner-decoder can demodulate only DE symbols in one OFDM subcarrier. In the frequency direction, the single-carrier Peleg-trellis inner-decoder can demodulate only DE symbols of one COFDM symbol. For DAB-family broadcast systems, the differential encoding is performed in the time direction. Specifically, when a single-carrier Peleg-trellis inner-decoder performs per OFDM subcarrier Multi-Symbol Differential Detection (MSDD), the length of the trellis, which may be the number of QPSK symbols for MSDD, is equal to the number of COFDM symbols that need to be processed. Due to per service symbol processing, the length of the trellis is rather limited and as a result, a significant loss in MSDD iterative coding gain may occur. To overcome the loss in MSDD iterative coding gain, the length of the trellis should be extended, which means, for a single-carrier Peleg-trellis inner-decoder, more COFDM symbols need to be processed and the receiver complexity will be increased. Using a multi-carrier Peleg-trellis inner-decoder, the length of the trellis is equal to the size of the two-dimensional code block, which is the product of the number of multiple COFDM symbols and the number of multiple OFDM subcarriers. As a result, compared to a single-carrier Peleg-trellis inner-decoder, by using a multi-carrier Peleg-trellis inner-decoder, the length of the trellis is extended, which enables per service symbol processing with almost no loss in MSDD iterative coding gain.

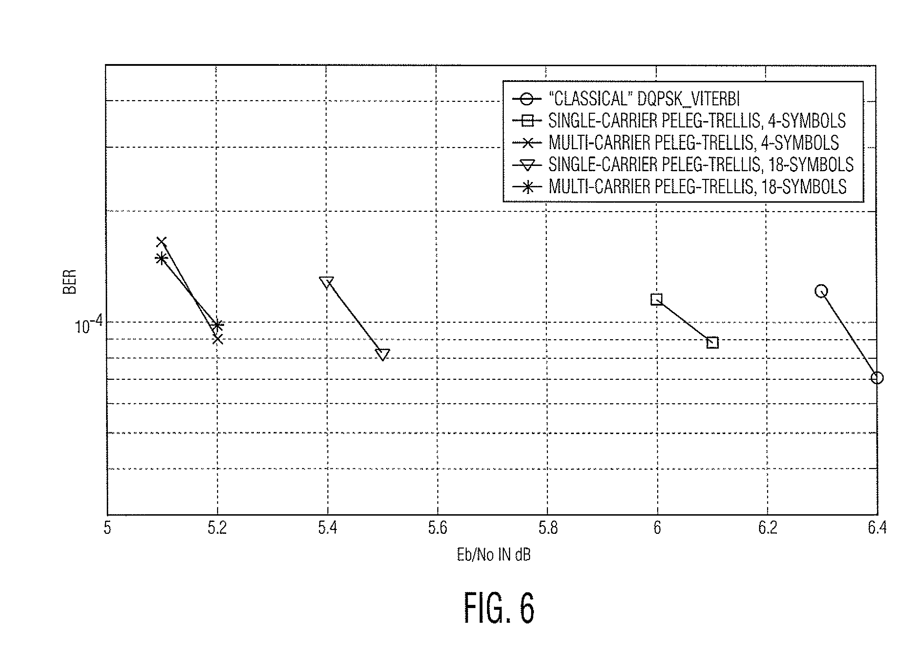

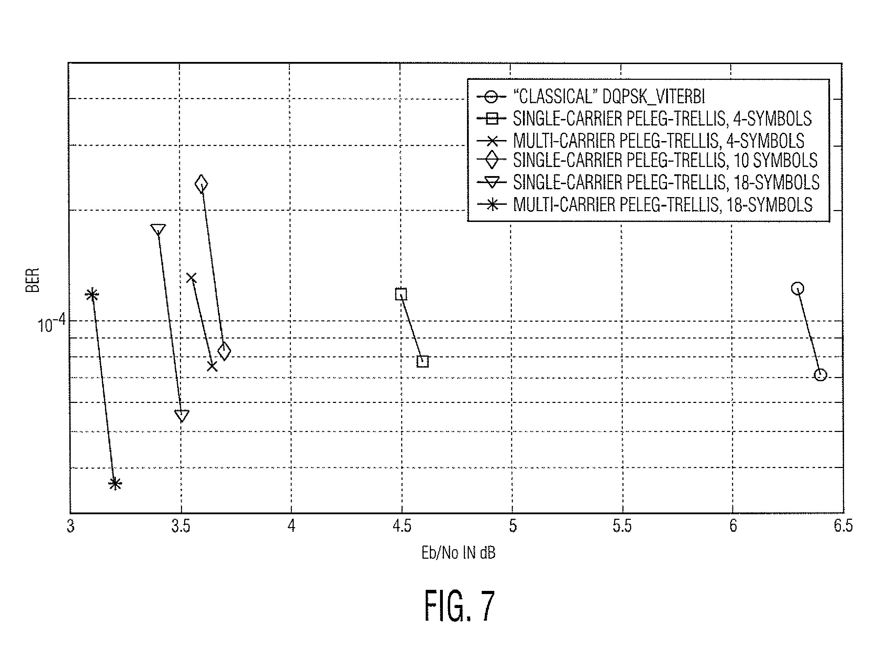

Figs. 6 and 7 depict performance simulation results of a single carrier Peleg-trellis inner-decoder and a multi-carrier Peleg-trellis inner-decoder in accordance with different embodiments of the invention. The simulations are performed in transmission Mode-I of DAB-family broadcast systems for four, ten and eighteen COFDM symbols at a bit error probability (BER) of $1 \times 10^{-4}$ for an AWGN channel. Specifically, Fig. 6 shows simulation results without iterative decoding and Fig. 7 shows simulation results with only one iteration iterative decoding. As shown in Figs. 6 and 7, the multi-carrier Peleg-trellis decoder with per service symbol processing outperforms the "classical" DQPSK detection and Viterbi decoding with soft-decisions by 1.2 dB without iterative decoding and by 2.8 dB with only one iteration iterative decoding. As also shown in Figs. 6 and 7, with comparable receiver complexity, i.e., four COFDM symbol processing, the multi-carrier Peleg-trellis inner-decoder outperforms the single carrier Peleg-trellis by approximately 0.9 dB. Additionally, Figs. 6 and 7 show that for obtaining almost identical MSDD iterative coding gain, the multi-carrier Peleg-trellis inner-decoder only needs four COFDM symbols, while the single-carrier Peleg-trellis inner-decoder requires eighteen COFDM symbols without iterative decoding, which is four and a half times of the number of COFDM symbols required for the multi-carrier Peleg-trellis inner-decoder, and ten COFDM symbols with only one iteration iterative decoding, which is two and a half times of the number of COFDM symbols required for the multi-carrier Peleg-trellis inner-decoder. Consequently, the receiver complexity is increased up to a factor of four and a half without iterative decoding and two and a half with only one iteration iterative decoding for the single-carrier Peleg-trellis inner-decoder, compared to the multi-carrier Peleg-trellis inner-decoder.

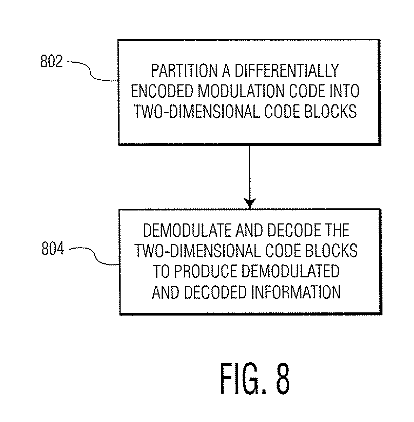

Fig. 8 is a process flow diagram of a method for demodulating and decoding a DE modulation code from a COFDM transmitter in accordance with an embodiment of the invention. At block 802, the DE modulation code is partitioned into two-dimensional code blocks. At block 804, the two-dimensional code blocks are demodulated and decoded to produce demodulated and decoded information.

The various components or units of the embodiments that have been described or depicted may be implemented in hardware, software that is stored in a computer readable medium or a combination of hardware and software that is stored in a computer readable medium. The computer readable medium can be an electronic, magnetic, optical, electromagnetic, infrared, or semiconductor system (or apparatus or device), or a propagation medium. Examples of a computer-readable medium include a semiconductor or solid state memory, magnetic tape, a removable computer diskette, a random access memory (RAM), a read-only memory (ROM), a rigid magnetic disk, and an optical disk. Current examples of optical disks include a compact disk with read only memory (CD-ROM), a compact disk with read/write (CD-R/W), a digital video disk (DVD), and a Blu-ray disk. Furthermore, the various components or units of the embodiments that have been described or depicted may be implemented in a processor, which may include a multifunction processor and/or an application-specific processor.

Although the operations of the method herein are shown and described in a particular order, the order of the operations of the method may be altered so that certain operations may be performed in an inverse order or so that certain operations may be performed, at least in part, concurrently with other operations. In another embodiment, instructions or sub-operations of distinct operations may be implemented in an intermittent and/or alternating manner.

Although specific embodiments of the invention that have been described or depicted include several components described or depicted herein, other embodiments of the invention may include fewer or more components to implement less or more functionality.

Although specific embodiments of the invention have been described and depicted, the invention is not to be limited to the specific forms or arrangements of parts so described and depicted. The scope of the invention is to be defined by the claims appended hereto and their equivalents.

**Claims**

1. A method for demodulating and decoding a differentially encoded (DE) modulation code from a coded orthogonal frequency division multiplexing (COFDM) transmitter, the method comprising:

   partitioning the DE modulation code into two-dimensional code blocks; and
   demodulating and decoding the two-dimensional code blocks to produce demodulated and decoded information.

2. The method of claim 1, wherein the DE modulation code comprises COFDM symbols, wherein the partitioning the DE modulation code comprises partitioning the COFDM symbols into the two-dimensional code blocks such that each of the two-dimensional code blocks comprises multiple COFDM symbols, wherein each of the multiple COFDM symbols comprises a plurality of DE symbols, and the method further comprising receiving each of the plurality of DE symbols in a different OFDM subcarrier.

3. The method of claim 2, wherein the demodulating and decoding the two-dimensional code blocks further comprises jointly demodulating and decoding the two-dimensional code blocks, wherein the jointly demodulating and decoding the two-dimensional code blocks comprises demodulating the two-dimensional code blocks using information from decoding the two-dimensional code blocks and decoding the two-dimensional code blocks using information from demodulating the two-dimensional code blocks.

4. The method of claim 3, wherein the demodulating and decoding the two-dimensional code blocks further comprises iteratively demodulating and decoding the two-dimensional code blocks.

5. The method of claim 4, wherein the demodulating and decoding the two-dimensional code blocks further comprises performing trellis decoding on each of the two-dimensional code blocks.

6. The method of claim 5 further comprising receiving concatenated DE symbols of the multiple COFDM symbols in adjacent OFDM subcarriers, wherein the performing the trellis decoding on each of the two-dimensional code blocks comprises performing the trellis decoding on the concatenated DE symbols successively, and wherein the concatenated DE symbols belong to a single COFDM symbol.

7. The method of claim 3, wherein the performing the trellis decoding on each of the two-dimensional code blocks comprises:

   for each of the DE symbols of the two-dimensional code block,
   setting discrete phases to represent trellis states, wherein the discrete phases are equally spaced from each other; and
   comparing a phase of the DE symbol with the discrete phases to select a trellis state for the DE symbol from the trellis states.

8. The method of claim 7, wherein the performing the trellis decoding on each of the two-dimensional code blocks further comprises uniquely determining a path through the trellis states using the discrete phases of the DE symbols of the two-dimensional code block.

9. The method of claim 7, wherein the performing the trellis decoding on each of the two-dimensional code blocks further comprises obtaining reliability information about the DE symbols of the two-dimensional code block, and wherein the demodulating and decoding the two-dimensional code blocks further comprises calculating reliability information about coded bits that are contained in the DE symbols of the two-dimensional code block using an outer-decoder, wherein the performing the trellis decoding further comprises calculating a-posteriori probability information of transitions between the trellis states using the calculated reliability information about the coded bits.

10. The method of claim 9, wherein the performing the trellis decoding on each of the two-dimensional code blocks further comprises performing the trellis decoding on each of the two-dimensional code blocks using the calculated a-posteriori probability information.

**11.** The method of claim 9, wherein the performing the trellis decoding on each of the two-dimensional code blocks further comprises performing the trellis decoding on each of the two-dimensional code blocks using a Peleg-trellis inner-decoder.

**12.** A system for demodulating and decoding a differentially encoded (DE) modulation code from a coded orthogonal frequency division multiplexing (COFDM) transmitter, the system comprising:

> a partitioning module configured to partition the DE modulation code into two-dimensional code blocks; and
> a demodulating and decoding module configured to demodulate and decode the two-dimensional code blocks to produce demodulated and decoded information.

**13.** The system of claim 12, wherein the DE modulation code comprises COFDM symbols, wherein the partitioning module is further configured to partition the COFDM symbols into the two-dimensional code blocks such that each of the two-dimensional code blocks comprises multiple COFDM symbols, wherein each of the multiple COFDM symbols comprises a plurality of DE symbols, and the system further comprising an OFDM receiving unit configured to receive each of the plurality of DE symbols in a different OFDM subcarrier.

**14.** The system of claim 13, wherein the demodulating and decoding module comprises an inner-decoder that is connected to the OFDM receiving unit and is configured to perform trellis decoding on each of the two-dimensional code blocks, wherein for each of the DE symbols of the two-dimensional code block, the inner-decoder is further configured to set discrete phases to represent trellis states, the discrete phases being equally spaced from each other, and to compare a phase of the DE symbol with the discrete phases to select a trellis state for the DE symbol from the trellis states.

**15.** The system of claim 14, wherein the inner-decoder is further configured to obtain reliability information about the DE symbols of the two-dimensional code block, wherein the demodulating and decoding module further comprises an outer-decoder configured to calculate reliability information about the coded bits that are contained in the DE symbols of the two-dimensional code block, wherein the inner-decoder is further configured to calculate a-posteriori probability information of transitions between the trellis states using the calculated reliability information about the coded bits.

SYSTEM FOR DEMODULATING AND DECODING — 102

100

CODED OFDM TRANSMITTER

DIFFERENTIALLY ENCODED MODULATION CODE

104

PARTITIONING MODULE

TWO-DIMENSIONAL CODE BLOCKS

106

DEMODULATING AND DECODING MODULE

DEMODULATED AND DECODED INFORMATION

FIG. 1

CODED OFDM TRANSMITTER

$b_i$ → CONVOLUTIONAL ENCODER (202) → $x_i$ → INTERLEAVER (204) → $x_j$ → MODULATION ENCODER (206) [ CONSTELLATION MAPPER (212) → DIFFERENTIAL ENCODER (210) ] → $S_l$ → OFDM TRANSMITTING UNIT (208) → $S_{n,k}$

200

PHASE NOISY CHANNEL (214) → $r_{n,k}$

SYSTEM FOR DEMODULATING AND DECODING (216)

DEMODULATING AND DECODING MODULE (220)

$\hat{b}_i$ ← OUTER-DECODER (230) ← $\lambda_i$ ← DEINTERLEAVER (226) ← $\lambda_j$ ← INNER-DECODER (224) ← $r_l$ ← PARTITIONING MODULE (218)

$\hat{p}(x_i)$ → INTERLEAVER (228) → $\hat{p}(x_j)$

OFDM RECEIVING UNIT (222)

FIG. 2

300

FREQUENCY ⟶  OFDM SUBCARRIERS

|  | k=1 | k=2 | k=3 | k=4 | | k=1533 | k=1534 | k=1535 | k=1536 |

TIME

1ST COFDM SYMBOL

2ND COFDM SYMBOL

3RD COFDM SYMBOL

4TH COFDM SYMBOL

FIG. 3

EP 2 323 327 A2

400

FREQUENCY ——→    OFDM SUBCARRIERS

k=1      k=2      k=3      k=4                    k=1533   k=1534   k=1535   k=1536

1ST COFDM SYMBOL

TIME

2ND COFDM SYMBOL

3RD COFDM SYMBOL

4TH COFDM SYMBOL

## FIG. 4

FIG. 5

DIFFERENTIALLY ENCODED SYMBOLS

EP 2 323 327 A2

FIG. 6

EP 2 323 327 A2

FIG. 7

EP 2 323 327 A2

802 ⟶ PARTITION A DIFFERENTIALLY
ENCODED MODULATION CODE INTO
TWO-DIMENSIONAL CODE BLOCKS

804 ⟶ DEMODULATE AND DECODE THE
TWO-DIMENSIONAL CODE BLOCKS
TO PRODUCE DEMODULATED
AND DECODED INFORMATION

FIG. 8

**EP 2 323 327 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **L. Bahl ; J. Cocke ; F. Jelinek ; J. Raviv.** Optimal decoding of linear codes for minimizing symbol error rate (corresp). *Information Theory, IEEE Transactions on,* March 1974, vol. 20 (2), 284-287